# EUROPÄISCHE PATENTSCHRIFT

(11) **EP 0 942 537 B1**
(45) Veröffentlichungstag und Bekanntmachung des Hinweises auf die Patenterteilung: **16.06.2004**
(21) Anmeldenummer: 99200617.1
(22) Anmeldetag: 03.03.1999
(51) Int. Cl.: H03M 1/10

(54) **Schaltungsanordnung zur Kontrolle einer Ausgangslast**
Circuit configuration for monitoring an output load
Configuration de circuit pour la contrôle d'une charge de sortie

(30) Priorität: 11.03.1998 DE 19810469
(43) Veröffentlichungstag der Anmeldung: 15.09.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Meyer, Robert, c/o Philips Patentverwaltung GmbH, 22335 Hamburg (DE); Pfarrkircher, Othmar, Röntgenstrasse 24, 22335 Hamburg (DE)
(74) Vertreter: von Laue, Hanns-Ulrich

(56) Entgegenhaltungen:
- PATENT ABSTRACTS OF JAPAN vol. 1999, no. 07, 31. März 1999 (1999-03-31) & JP 09 181606 A (SAMSUNG ELECTRON CO LTD), 11. Juli 1997 (1997-07-11)
- WALBROU P: "An analog to digital interface for digital video signal processing" IEEE, 1989, XP010085494
- PATENT ABSTRACTS OF JAPAN vol. 1995, no. 01, 28. Februar 1995 (1995-02-28) & JP 06 303477 A (SONY CORP), 28. Oktober 1994 (1994-10-28)
- PATENT ABSTRACTS OF JAPAN vol. 018, no. 584 (P-1823), 8. November 1994 (1994-11-08) & JP 06 214936 A (OKI ELECTRIC IND CO LTD), 5. August 1994 (1994-08-05)
- HILL R L ET AL: "Video subsystem design for EMI control" ELECTROMAGNETIC COMPATIBILITY, 1991. SYMPOSIUM RECORD., IEEE 1991 INTERNATIONAL SYMPOSIUM ON CHERRY HILL, NJ, USA 12-16 AUG. 1991, NEW YORK, NY, USA,IEEE, US, 12. August 1991 (1991-08-12), Seiten 134-141, XP010051518 ISBN: 0-7803-0158-7

## Beschreibung

Die Erfindung betrifft eine Schaltungsanordnung zur Kontrolle einer Ausgangslast eines Strom-Digital-Analog-Konverters, der in Abhängigkeit eines digitalen Datenwortes einen analogen Ausgangsstrom liefert, welcher einem ersten Widerstand und gegebenenfalls der diesem parallelgeschalteten Ausgangslast zugeführt wird.

In derartigen bekannten Schaltungsanordnungen wird nur einmalig, meist beim Einschalten der Anordnung, die sich beispielsweise in einem PC befinden kann, die Ausgangsspannung, die über dem oder den Widerständen abfällt, kontrolliert. Dazu wird ein bestimmtes Datenwort angelegt und die an den Widerständen abfallende Spannung mit einer Referenzspannung verglichen, wie in Dokument JP 09181606 A beschrieben. Bei diesem einmaligen Vergleich kann nur festgestellt werden, ob die Ausgangslast zu deisem Zeitpunkt vorhanden ist oder nicht. Ihre Größe kann nicht näher verifiziert werden. Wird die Ausgangslast während des Betriebes der Schaltungsanordnung entfernt, kann dies nicht detektiert werden.

Es ist Aufgabe der Erfindung, eine Schaltungsanordnung der eingangs genannten Art anzugeben, welche eine dauernde Überwachung der Ausgangslast gestattet.

Diese Aufgabe ist erfindungsgemäß dadurch gelöst, daß ein erster, digitaler Komparator vorgesehen ist, welcher die dem Strom-Digital-Analog-Konverter zugeführten Datenworte mit wenigstens einem Vergleichs-Datenwort vergleicht, daß ein zweiter, analoger Komparator vorgesehen ist, welcher die über dem ersten Widerstand abfallende Spannung mit wenigstens einer Referenzspannung vergleicht und dessen Ausgangssignal einem Flip-Flop zugeführt wird,
und daß eine Vergleichsschaltung vorgesehen ist, welche In Abhängigkeit der Ausgangssignale des ersten Komparators und des Flip-Flops eine Kontrolle der Größe und/oder der Existenz der Ausgangslast vornimmt.

Diese erfindungsgemäße Schaltungsanordnung gestattet es, eine dauernde Kontrolle der Ausgangslast vorzunehmen, das heißt dauernd zu kontrollieren, ob die Ausgangslast vorhanden ist und ob sie die vorgeschriebene Größe hat.

Dazu werden die im laufenden Betrieb dem Strom-Digital-Analog-Konverter zugeführten Datenworte einem ersten, digitalen Komparator zugeführt, der diese mit einem Vergleichs-Datenwort vergleicht. Dieser Vergleich ergibt zu jeder Zeit und für jedes Datenwort, ob dieses größer oder kleiner als das Vergleichs-Datenwort ist.

Es ist ein zweiter, jedoch analoger Komparator vorgesehen, der die über dem ersten Widerstand bzw. der Parallelschaltung der beiden Widerstände abfallende Spannung mit wenigstens einer Referenzspannung vergleicht. Die Größe des Spannungsabfalls ist abhängig davon, ob dem ersten Widerstand die externe Ausgangslast parallelgeschaltet ist und ob diese die vorgeschriebene Größe aufweist. Durch den Vergleich der beiden Spannungen mittels des Komparators und die Umwandlung dessen Ausgangssignal in ein digitales Signal mittels eines Flip-Flops entsteht ein Signal, welches einen dauernden Vergleich darüber liefert, welcher der beiden Spannungswerte größer ist.

Somit liefern die Ausgangssignale des ersten Komparators und des Flips-Flops im Prinzip eine gleichartige Information. Bei vorgeschriebenem Widerstand und bei korrekt angeschlossener Ausgangslast müßten beide Ausgangssignale etwa gleiche Taktverhältnisse liefern, d.h. also etwa gleiche Zeiten, zu denen jeweils die Datenworte bzw. die Ausgangsspannung größer als die Vergleichswerte und solche Zeiten, zu denen sie kleiner als die Vergleichswerte sind. Diese Auswertung wird durch eine Vergleichsschaltung vorgenommen, die aus diesen Tastverhältnissen Rückschlüsse auf die Existenz und Größe der Ausgangslast ziehen kann.

Insbesondere zur Verfeinerung der Identifizierung der Größe der Ausgangslast können mehrere Vergleichs-Datenworte bzw. Referenzspannungen verschiedener Größe vorgesehen sein, so daß eine feinere Abstufung der zu vergleichenden digitalen Worte bzw. analogen Spannungen vorgenommen werden kann.

Gewünschtenfalls kann der oben beschriebene Vergleich kontinuierlich in dem normalen Betrieb der Schaltungsanordnung bzw. des Strom-Digital-Analog-Konverters vorgenommen werden, so daß mittels der Vergleichsschaltung eine dauernde Kontrolle der Existenz und der Größe der Ausgangslast möglich ist. Auch im Betrieb der Schaltungsanordnung wird ein Entfernen der Ausgangslast sofort feststellbar. Ferner kann auch dann, wenn die Schaltungsanordnung ohne Ausgangslast in Betrieb genommen wurde, während des weiteren Betriebs ein korrektes Anschalten der Ausgangslast sofort festgestellt werden. Wird die Schaltungsanordnung beispielsweise in einem Personal Computer eingesetzt, findet eine Kontrolle nicht nur beim Booten des Computers, sondern bei dessen laufendem Betrieb statt.

Bei der gemäß einer Ausgestaltung der Erfindung gemäß Anspruch 2 vorgesehenen Auslegung kann alleine schon durch unmittelbaren Vergleich der Tastverhältnisse der beiden der Vergleichsschaltung zugeführten Signale ein Rückschluß auf die korrekte Anschaltung bzw. Größe der Ausgangslast gezogen werden.

Gemäß den weiteren Ausgestaltungen nach den Ansprüchen 3, 4 und 5 kann gegebenenfalls eine Vorverarbeitung der zu vergleichenden Signale vorgenommen werden, bevor diese der Vergleichsschaltung zugeführt werden. Damit kann die Signalverzögerung des Strom-Digital-Analog-Konverters ausgeglichen werden oder gegebenenfalls eine Glättung der Signale, eine Identifizierung der Tastverhältnisse bereits vor der Vergleichsschaltung vorgenommen werden.

Die erfindungsgemäße Schaltungsanordnung kann vorteilhaft zur Konvertierung von Video-Signalen eingesetzt werden, bei denen weitere Ausgestaltungen gemäß Anspruch 6 und 7 vorteilhaft einsetzbar ist.

Gemäß einer weiteren Ausgestaltung der Erfndung gemäß Anspruch 8 kann das Ergebnis der Identifikation der Ausgangslast dazu eingesetzt werden, das Ausgangssignal des Strom-Analog-Digital-Konverters zu unterdrücken oder abzuschalten. Es wird damit bei nicht vorhandener Ausgangslast kein Ausgangssignal geliefert.

Diese Unterdrückung des Ausgangssignals kann vorteilhaft, wie gemäß Anspruch 9 vorgesehen ist, durch die Vergleichsschaltung gesteuert werden.

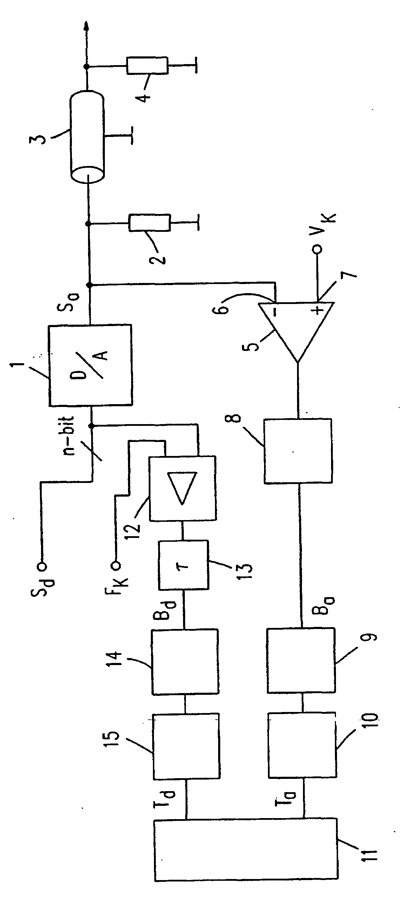

Nachfolgend wird ein Ausführungsbeispiel der Erfindung anhand der Zeichnung näher erläutert.

Die einzige Figur der Zeichnung zeigt in Form eines Blockschaltbildes eine erfindungsgemäße Schaltungsanordnung, welche einen Strom-Digital-Analog-Konverter 1 aufweist.

Dem Strom-Digital-Analog-Konverter 1 werden eingangsseitig n-bit breite Datenwrote S_{d} zugeführt, welche von diesem in den analogen Bereich konvertiert werden und als analoges Ausgangssignal Sₐ geliefert werden. Bei den Signalen S_{d} bzw. Sₐ kann es sich beispielsweise um Videosignale handeln.

Das analoge Signal Sₐ wird auf einen ersten, gegen ein Bezugspotential geschalteten Widerstand 2 geführt. Ferner wird es gegebenenfalls über ein Kabel 3 auf eine externe Ausgangslast 4 gegeben, welche ebenfalls gegen das Bezugspotential geschaltet ist.

Beispielsweise im Falle eines Videosignals für eine Anwendung in einem Personal Computer soll die Ausgangslast 4 75 Ohm betragen. Wird beispielsweise der erste Widerstand gleich groß gewählt, so ergibt sich insgesamt eine Ausgangslast von 37,5 Ohm, bei der die am Ausgang des Strom-Digital-Analog-Konverters 1 bzw. über den Widerstand 2 bzw. der Parallelschaltung der beiden Widerstände abfallende Spannung einen Sollwert von beispielsweise maximal 1 Volt erreicht. Wird die externe Ausgangslast 4 entfernt, so ist nur noch der erste Widerstand mit seinen 75 Ohm wirksam, so daß die Spannung am Ausgang des Strom-Digital-Analog-Konverters 1 bzw. über diesen Widerstand 2 doppelt so hoch ist wie bei korrekt angeschlossener Ausgangslast. Da eben dieser Effekt unerwünscht ist, wird nach dem Stande der Technik eine einmalige Überwachung der Ausgangsspannung beim Einschalten vorgenommen. Eine weitere Kontrolle ist dann nicht mehr möglich. Da sich jedoch das An- bzw. Abschalten der Ausgangslast auch während des Betriebs vollziehen kann, gestattet es die erfindungsgemäße Schaltungsanordnung gemäß der Figur, eine dauernde Kontrolle der Ausgangslast vorzunehmen.

Dazu wird die am Ausgang des Strom-Digital-Analog-Konverters 1 bzw. über den Widerstand 2 oder der Parallelschaltung der Widerstände 2 und 4 abfallende Ausgangsspannung einem invertierenden Eingang 6 eines analog arbeitenden Komparators 5 zugeführt. Einem nicht invertierenden Eingang 7 des Komparators 5 wird eine Vergleichsspannung V_{K} zugeführt. Der Komparator 5 vergleicht somit laufend die Ausgangsspannung mit der Vergleichsspannung. Abhängig von diesem Vergleich liefert er ein Ausgangssignal, welches mittels eines dem analog arbeitenden Komparator 5 nachgeschalteten digitalen Flip-Flops in ein digitales Ja-Nein-Signal umgewandelt wird. Das Ausgangssignal des Flip-Flops 8 liefert somit jederzeit eine Information darüber, ob die gerade am Ausgang des Strom-Digital-Analog-Konverters 1 abfallende Spannung größer oder kleiner als die Vergleichsspannung V_{K} ist.

Das von dem Flip-Flop gelieferte Signal Bₐ wird einem Tiefpaßfilter 9 und einer diesem nachgeschalteten Detektorschaltung 10 zugeführt, welche die Tastverhältnisse des Signales identifiziert und entsprechende Signale Tₐ an eine Vergleichsschaltung 11 liefert.

Durch die Schaltungselemente 5, 8, 9 und 10 gelingt es also insoweit, einen dauernden Vergleich der Ausgangsspannung mit der Vergleichsspannung vorzunehmen und, nach Umwandlung in den digitalen Bereich und Tiefpaßfilterung des entsprechenden Signales eine Identifizierung der entsprechenden Tastverhältnisse vorzunehmen, aus denen eine unmittelbare Aussage über die Zeitspannen möglich ist, zu denen die Ausgangsspannung größer bzw. kleiner als die Vergleichsspannung ist.

Es ist ferner ein zweiter, digital arbeitender Komparator 12 vorgesehen, dessen einem Eingang ein festes Vergleichsdatenwort F_{K} zugeführt wird und auf dessen zweiten Eingang das sich laufend ändernde Datenwort S_{d} geführt ist, das auch dem Strom-Digital-Analog-Konverter 1 zugeführt wird. Dabei sollten vorteilhaft die Verhältnisse des digitaler Maximalwert zu F_{K} und des analogen maximalen Ausgangsspannung zu V_{K} gleich gewählt werden.

Der zweite digital arbeitende Komparator 12 nimmt somit einen laufenden Vergleich dieser beiden Datenworte vor und gibt ein Ausgangssignal aus, welches laufend eine Information über das Vergleichsergebnis beinhaltet. Mittels eines dem zweiten Komparator 12 nachgeschalteten Laufzeitgliedes 13 wird die durch den Strom-Digital-Analog-Konverter 1 verursachte Signalverzögerung ausgeglichen. Das nunmehr entstandene Signal B_{d} wird einem Tiefpaßfilter 14 und einer diesem nachgeschalteten Detektorschaltung 15 zur Identifizierung der entsprechenden Tastverhältnisse zugeführt. Diese liefert ein Ausgangssignal T_{d}, welches entsprechend dem Signal Tₐ, welches von der ersten Detektorschaltung 10 geliefert wird, Informationen darüber ausgibt, welche Verhältnisse die Zeitspannen jeweils aufweisen, zu denen das digitale Datenwort bzw das analoge Ausgangssignal größer oder kleiner sind als das Vergleichsdatenwort F_{K} bzw. die Vergleichsspannung V_{K}.

Die Signale T_{d} und Tₐ werden mittels der Vergleichsschaltung 11 verglichen. Aus den jeweils auftretenden Tastverhältnissen kann unmittelbar darauf Rückschluß gezogen werden, ob die Ausgangslast vorhanden ist und ob sie etwa die vorgeschriebene Größe aufweist. Dabei können vorteilhafterweise die Größe des Vergleichsdatenwortes F_{K} und der Vergleichsspannung V_{K} so ausgelegt sein, daß bei korrekt angeschalteter Ausgangslast etwa jeweils gleiche Tastverhältnisse in den Signalen B_{d} und Bₐ auftreten und durch die Signale T_{d} und Tₐ signalisiert werden. Wird jedoch die Ausgangslast 4 entfernt, so werden diejenigen Zeitspannen, während derer die Spannung am Ausgang des Strom-Digital-Analog-Konverters 1 größer als die Vergleichsspannung ist, bezüglich ihrer Dauer deutlich zunehmen, so daß der Komparator 5 ein entsprechendes Vergleichsergebnis liefert, das letztlich in dem Signal Tₐ zu entsprechenden Tastverhältnissen führt. Da das Signal T_{d} sich jedoch hierdurch nicht verändert, signalisieren die beiden Signale deutlich unterschiedliche Tastverhältnisse, welche darauf hindeuten, daß die Ausgangslast entfernt wurde. Aus Größe und Vorzeichen der relativen Abweichung der Tastverhältnisse kann auf Umfang der Abweichung und auf Vorzeichen der Abweichung der Ausgangslast von einem Sollwert geschlossen werden. Ist beispielsweise die Ausgangslast zu klein, so fällt die Ausgangsspannung am Strom-Digital-Analog-Konverter 1 tiefer ab als dies bei normaler Ausgangslast der Fall wäre, so daß die Spannung während längerer Zeitspannen kleiner als die Vergleichsspannung ist. Das Signal Tₐ liefert entsprechende Ergebnisse, aus denen auf diese Veränderung geschlossen werden kann.

Zu einer weiteren Verfeinerung können gegebenenfalls mehrere Vergleichs-Datenworte F_{K} und Vergleichsspannungen V_{K} zum Vergleich herangezogen werden. Damit ist es möglich, die Spannungsverhältnisse noch genauer zu identifizieren.

In jedem Falle gestattet es die Schaltungsanordnung durch einen laufenden Vergleich der Digitalworte und der analogen Ausgangsspannung jederzeit festzustellen, ob die Ausgangslast 4 angeschlossen ist und etwa korrekte Größe aufweist.

In der Schaltung können vorteilhaft mehrere Vergleichsdatenworte und jeweils zugeordnete Referenzspannungen eingesetzt werden. Damit kann das Unterschreiten bzw. Überschreiten mehrerer Amplitudenwerte in den beiden Signalen miteinander verglichen werden und es können die entsprechenden Tastverhältnisse ausgewertet werden. Damit ist eine noch feinere Überwachung der Ausgangsspannung möglich.

Die Schaltung kann auch dazu eingesetzt werden, die Ausgangsamplitude des Strom-Digital-Konverters 1 wunschgemäß einzustellen. Dazu wird das Vergleichsdatenworten angelegt und mit der Referenzspannung verglichen. Die Ausgangsamplitude des Strom-Digital-Analog-Konverters ist dann richtig eingestellt, wenn sich für die Auswertung beider Signale etwa gleiche Tastverhältnisse ergeben.

Die Schaltungsanordnung kann auch zur Überwachung der Signalbandbreite des Ausgangssignals Sₐ oder zur Überwachung einer Fremdeinspeisung eines externen Signals durch die Ausgangslast eingesetzt werden.

Zur Überwachung einer derartigen Fremdeinspeisung wird intern der Ausgang des Strom-Digital-Analog-Konverters 1 hochohmig geschaltet. Mittels des analogen Komparators wird gemessen, ob ein Signal ungleich konstant low anliegt. Ist dies nicht der Fall, so deutet dies darauf hin, daß vom Ausgang bzw. von der Ausgangslast her ein Signal eingespeist wird, also eine Fremdeinspeisung vorliegt.

## Patentansprüche

1. Schaltungsanordnung zur Kontrolle einer Ausgangslast (4) eines Strom-Digital-Analog-Konverters (1), der in Abhängigkeit eines digitalen Datenwortes einen analogen Ausgangsstrom liefert, welcher einem ersten Widerstand (2) und gegebenenfalls der diesem parallelgeschalteten Ausgangslast (4) zugeführt wird, indem ein zweiter, analoger Komparator (5) vorgesehen ist, welcher die über dem ersten Widerstand (2) abfallende Spannung mit wenigstens einer Referenzspannung vergleicht und dessen Ausgangssignal einem Flip-Flop (8) zugeführt wird,
**dadurch gekennzeichnet,**
**daß** ein erster, digitaler Komparator (12) vorgesehen ist, welcher die dem Strom-Digital-Analog-Konverter (1) zugeführten Datenworte mit wenigstens einem Vergleichs-Datenwort vergleicht,
und **daß** eine Vergleichsschaltung (11) vorgesehen ist, welche In Abhängigkeit der Ausgangssignale des ersten Komparators (12) und des Flip-Flops (8) eine Kontrolle der Größe und/oder der Existenz der Ausgangslast (4) vornimmt.

2. Schaltungsanordnung nach Anspruch 1, **dadurch gekennzeichnet, daß** das Vergleichs-Datenwort und die Referenzspannung so ausgelegt sind, daß bei angeschlossener Ausgangslast (4) einer Soll-Widerstandsgröße in den Ausgangssignalen des ersten Komparators (12) und des Flip-Flops (8) jeweils etwa gleiche Tastverhältnisse auftreten.

3. Schaltungsanordnung nach Anspruch 1, **dadurch gekennzeichnet, daß** der Vergleichsschaltung (11) Filter (9,14) vorgeschaltet sind, welche die der Vergleichsschaltung (11) zugeführten Signale einer Tiefpaßfilterung unterziehen.

4. Schaltungsanordnung nach Anspruch 1, **dadurch gekennzeichnet, daß** der Vergleichsschaltung (11) Detektorschaltungen (10,15) vorgeschaltet sind, welche die jeweiligen Tastverhältnisse der der Vergleichsschaltung (11) zugeführten Signale detektieren und an die Vergleichsschaltung (11) liefern.

5. Schaltungsanordnung nach Anspruch 1, **dadurch gekennzeichnet, daß** das Ausgangssignal des ersten, digitalen Komparators (12) ein Laufzeitglied durchläuft, welches die Signalverzögerung des Strom-Digital-Analog-Konverters kompensiert.

6. Schaltungsanordnung nach Anspruch 1, **dadurch gekennzeichnet, daß** der Strom-Digital-Analog-Konverter (1) zur Konvertierung eines Video-Signals vorgesehen ist, daß der erste Widerstand (2) einen Widerstandswert von 75 Ohm aufweist, daß die Ausgangslast (4) einen Soll-Widerstand von 75 Ohm aufweist und daß das Vergleichs-Datenwort und die Referenzspannung so ausgelegt sind, daß bei diesem Widerstandswert der Ausgangslast (4) die der Vergleichsschaltung (11) zugeführten Signale etwa gleiche Tastverhältnisse aufweisen.

7. Schaltungsanordnung nach Anspruch 1, **dadurch gekennzeichnet, daß** als Ausgangslast (4) ein Computer-Monitor mit einem Widerstandswert von etwa 75 Ohm vorgesehen ist.

8. Schaltungsanordnung nach Anspruch 1, **dadurch gekennzeichnet, daß** die Vergleichsschaltung (11) die Schaltungsanordnung so steuert, daß sie bei nicht identifizierter Ausgangslast (4) während einer vorgebbaren Zeitspanne kein Ausgangssignal liefert.

9. Schaltungsanordnung nach Anspruch 1, **dadurch gekennzeichnet, daß** die Vergleichsschaltung (11) die Schaltungsanordnung so steuert, daß sie bei einer Ausgangslast (4), deren Widerstandswert um einen vorgegebenen Wert von dem der Soll-Ausgangslast abweicht, kein Ausgangssignal liefert.

10. Schaltungsanordnung nach Anspruch 1, **dadurch gekennzeichnet, daß** jeweils mehrere zugeordnete Vergleichsdatenworte und Referenzspannungen vorgesehen sind.

11. Verwendung der Schaltungsanordnung nach einem der Ansprüche 1 bis 10 für Computer-Grafikschaltungen.

12. Verwendung der Schaltungsanordnung nach einem der Ansprüche 1 bis 10 zum Abgleich der Ausgangsamplitude des Strom-Digital-Analog-Konverters (1).

13. Verwendung der Schaltungsanordnung nach einem der Ansprüche 1 bis 10 zur Überwachung der Bandbreite des Ausgangssignals des Strom-Digital-Analog-Konverters (1).

14. Verwendung der Schaltungsanordnung nach einem der Ansprüche 1 bis 10 zur Überwachung eines gegebenfalls durch die Ausgangslast (4) eingespeisten externen Signals.

## Claims

1. A circuit arrangement for monitoring an output load (4) of a digital-to-analog current converter (1) which supplies an analog output current in dependence on a digital comparison data word, which output current is applied to a first resistor (2) and, if present, the output load (4) arranged in parallel with said first resistor, in that a second analog comparator (5) is provided which compares the voltage that drops across the first resistor (2) with at least a reference voltage and whose output signal is applied to a flip-flop (8), **characterized in that** a digital first comparator (12) is provided which compares the data words applied to the digital-to-analog current converter (1) with at least one comparison data word, and **in that** a comparison circuit (11) is provided which monitors the magnitude and/or the presence of the output load (4) in dependence on the output signals of the first comparator (12) and the flip-flop (8).

2. A circuit arrangement as claimed in Claim 1, **characterized in that** the comparison data word and the reference voltage are dimensioned in such a manner that substantially equal duty cycles occur in the output signals of the first comparator (12) and the flip-flop (8) when the output load (4) is connected.

3. A circuit arrangement as claimed in Claim 1, **characterized in that** the comparison circuit (11) is preceded by filters (9, 14) which subject the signals applied to the comparison circuit (11) to a low-pass filtering.

4. A circuit arrangement as claimed in Claim 1, **characterized in that** the comparison circuit (11) is preceded by detector circuits (10, 15) which detect the instantaneous duty cycles of the signals applied to the comparison circuit (11) and supplies them to the comparison circuit (11).

5. A circuit arrangement as claimed in Claim 1, **characterized in that** the output signal of the digital first comparator (2) is passed through a delay element which compensates for the signal delay in the digital-to-analog current converter.

6. A circuit arrangement as claimed in Claim 1, **characterized in that** the digital-to-analog current converter (1) is adapted to convert a video signal, **in that** the first resistor (2) has a resistance value of 75 ohms, **in that** the output load (4) has a nominal resistance of 75 ohms, and **in that** the comparison data word and the reference voltage are dimensioned in such a manner that for this resistance value of the output load (4) the signals applied to the comparison circuit (11) have substantially equal duty cycles.

7. A circuit arrangement as claimed in Claim 1, **characterized in that** the output load (4) is a computer monitor having a resistance value of approximately 75 ohms.

8. A circuit arrangement as claimed in Claim 1, **characterized in that** the comparison circuit (11) controls the circuit arrangement in such a manner that its supplies no output signal if no output load (4) has been detected for a given time interval.

9. A circuit arrangement as claimed in Claim 1, **characterized in that** the comparison circuit (11) controls the circuit arrangement in such a manner that it does not supply an output signal in the case of a output load (4) whose resistance value deviates by a given value from that of the nominal value output load.

10. A circuit arrangement as claimed in Claim 1, **characterized in that** a plurality of associated comparison data words and reference voltages are provided at a time.

11. Use of the circuit arrangement as claimed in any one of the Claims 1 to 10 for computer graphics circuits.

12. Use of the circuit arrangement as claimed in any one of the Claims 1 to 10 for controlling the output amplitude of the digital-to-analog current converter (1).

13. Use of the circuit arrangement as claimed in any one of the Claims 1 to 10 for monitoring the bandwidth of the output signal of the digital-to-analog current converter (1).

14. Use of the circuit arrangement as claimed in any one of the Claims 1 to 10 for monitoring an external signal which is possibly fed in through the output load (4).

## Revendications

1. Montage du circuit en vue du contrôle d'une charge de sortie (4) d'un convertisseur numérique/analogique de courant (1) qui, en fonction d'un mot de données numérique, délivre un courant de sortie analogique qui est amené à une première résistance (2) et, éventuellement, à la charge de sortie (4) montée en parallèle à celle-ci par le fait qu'il est prévu un deuxième comparateur analogique (5) qui compare la tension appliquée sur la première résistance (2) avec au moins une tension de référence et que son signal de sortie est amené à une bascule bistable (8),
**caractérisé en ce qu'**il est prévu un premier comparateur numérique (12) qui compare les mots de données amenés au convertisseur numérique/analogique de courant (1) avec au moins un mot de données de comparaison
et qu'il est prévu un circuit de comparaison (11) qui procède à un contrôle de la grandeur et/ou de l'existence de la charge de sortie (4) en fonction des signaux de sortie du premier comparateur (12) de la bascule bistable (8).

2. Montage de circuit selon la revendication 1, **caractérisé en ce que** le mot de données de comparaison et la tension de référence sont conçus de telle sorte qu'en cas de charge de sortie (4) raccordée d'une grandeur de résistance de consigne, il se produit respectivement les mêmes facteurs d'utilisation dans les signaux de sortie du comparateur (12) et de la bascule bistable (8).

3. Montage de circuit selon la revendication 1, **caractérisé en ce qu'**en amont du circuit de comparaison (11) sont montés des filtres (9, 14) qui soumettent les signaux amenés au circuit de comparaison (11) à un filtrage passe-bas.

4. Montage de circuit selon la revendication 1, **caractérisé en ce qu'**en amont du circuit de comparaison (11) sont montés des circuits détecteurs (10, 15) qui détectent les facteurs d'utilisation respectifs des signaux amenés au circuit de comparaison (11) et les délivrent au circuit de comparaison (11).

5. Montage de circuit selon la revendication 1, **caractérisé en ce que** le signal de sortie du premier comparateur numérique (12) traverse une bascule de retard qui compense le retard du signal du convertisseur numérique/analogique de courant.

6. Montage de circuit selon la revendication 1, **caractérisé en ce que** le convertisseur numérique/analogique de courant (1) est prévu pour la conversion d'un signal vidéo, que la première résistance (2) présente une valeur de résistance de 75 ohms, que la charge de sortie (4) présente une résistance de consigne de 75 ohms et que le mot de données de comparaison et la tension de référence sont conçus de telle sorte qu'à cette valeur de résistance de la charge de sortie (4), les signaux amenés au circuit de comparaison (11) présentent à peu près les mêmes facteurs d'utilisation.

7. Montage de circuit selon la revendication 1, **caractérisé en ce qu'**un moniteur d'ordinateur avec une valeur de résistance d'environ 75 ohms est prévu comme charge de sortie (4).

8. Montage de circuit selon la revendication 1, **caractérisé en ce que** le circuit de comparaison (11) commande le montage de circuit de telle sorte qu'il ne délivre pas de signal de sortie en cas de charge de sortie (4) non identifiée pendant un intervalle de temps à déterminer préalablement.

9. Montage de circuit selon la revendication 1, **caractérisé en ce que** le circuit de comparaison (11) commande le montage de circuit de telle sorte qu'il ne délivre pas de signal de sortie en cas de charge de sortie (4) dont la valeur de résistance diffère d'une valeur préalablement déterminée de celle de la charge de sortie de consigne.

10. Montage de circuit selon la revendication 1, **caractérisé en ce que** plusieurs mots de données de comparaison affectés et tension de référence sont respectivement prévus.

11. Mise en oeuvre du montage de circuit selon l'une des revendications 1 à 10, pour des circuits graphiques informatiques.

12. Mise en oeuvre du montage de circuit selon l'une des revendications 1 à 10, en vue de l'égalisation de l'amplitude de sortie du convertisseur numérique/analogique de courant (1).

13. Mise en oeuvre du montage de circuit selon l'une des revendications 1 à 10, en vue du contrôle de la largeur de bande du signal de sortie et du convertisseur numérique/analogique de courant (1).

14. Mise en oeuvre du montage de circuit selon l'une des revendications 1 à 10, en vue du contrôle d'un signal externe éventuellement alimenté par la charge de sortie (4).
